# EUROPEAN PATENT APPLICATION

(11) **EP 1 482 565 A1**
(43) Date of publication of application: **01.12.2004**
(21) Application number: 03708513.1
(22) Date of filing: 07.03.2003
(51) Int. Cl.: H01L 31/04

(54) **PHOTOELECTRIC CONVERTING DEVICE**

(30) Priority: 07.03.2002 JP 2002062589
(71) Applicant: Nippon Oil Corporation, Tokyo 105-8412 (JP)
(72) Inventor: Nishikitani, Yoshinori, Yokohama-shi, Kanagawa 231-0815 (JP); Asano, Tsuyoshi, Yokohama-shi, Kanagawa 231-0815 (JP); Uchida, Souichi, Yokohama-shi, Kanagawa 231-0815 (JP); Tanimoto, Junichiro, Yokohama-shi, Kanagawa 231-0815 (JP)
(74) Representative: Grünecker, Kinkeldey, Stockmair & Schwanhäusser Anwaltssozietät
(86) International application number: PCT/JP2003/002725
(87) International publication number: WO 2003/075364

(57) **Abstract**

Organic photoelectric converting devices used for photovoltaic power generation or a photovoltaic power generating system has a photoelectric converting layer comprising a block copolymer constituted by at least a polymer unit having an electron-donating molecular structure and a polymer unit having an electron-accepting molecular structure. The photoelectric converting layer can suppress macro phase separation of the donor and the acceptor, leading to efficient, charge separation and has excellent carrier mobility.

## Description

### [Field of the Invention]

The present invention relates to photoelectric converting devices useful for photovoltaic generators or photovoltaic generating systems.

### [Background of the Invention]

In recent years, due to an increased awareness of environmental issues, attention has been attracted to solar power or energy which is an inexpensive and clean energy source as an alternative for fossil fuels causing carbon dioxide emission having an effect on the global warming. Conversion of solar energy to other energies such as electric energy is important for the effective use of solar energy. In this connection, inorganic semiconductor-type photoelectric generators, such as silicon have been developed and put to practical use. However, such photoelectric generators are enormous in production energy, and it has been desired to develop a photoelectric converting device which can be produced with a low energy and cost consumption.

Organic compounds are inexpensive and give less affect to the environment even though incinerated after use. With this background in view, the development of a photoelectric converting device using organic photoelectric converting molecules is one of the important energy measures.

Interests to the photoelectric converting device using organic photoelectric converting molecules have been increased since the Tang's converting device exhibited about 1 percent efficiency in 1986 (C. W. Tang. Appl. Phys. Lett., 48, 183 (1986)). Thereafter, the photoelectric converting efficiency has been improved year by year. For enhancing the efficiency of the organic photoelectric converting device, it is necessary to establish a combination of an electron-donating organic semiconductor (donor) and an electron-accepting organic semiconductor (acceptor), so-called heterojunction structure. An effective charge separation occurs in the proximity of the interface between the donor and the acceptor. Based on such an idea, for example, U. S. Patent Nos. 5,454,880 and 5, 331,183 proposed a so-called bulk heterojunction wherein an electric conductive polymer as a donor and a fullerene derivative as an acceptor are mixed, thereby developing a photoelectric converting device with a higher density donor/acceptor interface, resulting in an enhanced photoelectric converting efficiency. Therefore, the key factor in the development of an organic photoelectric converting device in recent years is in what way the charge separation interface between the donor and the acceptor is designed.

For developing a photoelectric converting device with an enhanced photoelectric converting efficiency, it is also important to transport efficiently carriers (electrons, holes) generated after charge separation. Friend et al. succeeded in producing a structure with a high carrier mobility efficiency by using an electron-donating benzocoronen and an electron-accepting perylene dye, stacking by self-organization (L. Schmidt-Mende, A. Fechtenkoetter, K. Muellen, E. Moons, R. H. Friend, J. D. MacKenzie, Science, 293, 1119 (2002)). Stacking of π conjugated systems exhibits a large carrier mobility with respect to the lamination direction.

However, a strong tendency of self-organizing of molecules causes the molecules of donors and acceptors to gather with the same ones, respectively upon production of a photoelectric converting device, resulting in the possibility of macro phase separation. When the macro separation occurs, a rugged surface is formed on the photoelectric converting layer and prevents the carriers from moving. Furthermore, exciton (electron-hole pairs) generated by optical absorption in the domains developed by the macro phase separation deactivates to the ground state before reaching the donor/acceptor interface and thus decreases photoelectric converting properties.

The present invention was made in view of the above-described circumstances and thus relates to a photoelectric converting material enabling a production of a photoelectric converting layer capable of suppressing macro phase separation, leading to efficient charge separation and having excellent carrier mobility (drifting) function and also to a photoelectric converting device using the photoelectric converting material.

### [Disclosures of the Invention]

As a result of the studies by the inventors of the present invention, the present invention was achieved based on the finding that a photoelectric converting device with excellent properties as described above was obtained using a block copolymer characterized by being constructed by at least a polymer unit comprising an electron-donating molecular structure and a polymer unit comprising an electron-accepting molecular structure.

That is, the present invention relates to a photoelectric converting device wherein it has a photoelectric converting layer comprising a block copolymer constructed by at least a polymer unit containing an electron-donating molecular structure and a polymer unit containing an electron-accepting molecular structure.

In the photoelectric converting device of the present invention, the electron-donating and electron-accepting molecular structures of the block copolymer preferably exist in the main chain of the respective polymer units.

In the photoelectric converting device of the present invention, the polymer units comprising the electron-donating molecular structure and the electron-accepting molecular structure, respectively are preferably those having a carrier mobile function.

In the photoelectric converting device of the present invention, the domain size of the micro phase separation structure formed by the block copolymer is preferably 10 times or less of the exciton diffusion length.

In the photoelectric converting device of the present invention, the domain structure of the micro phase separation structure formed by the block copolymer preferably forms a continuous layer.

In the photoelectric converting device of the present invention, the domain structure formed by the block copolymer is preferably a quantum well structure.

The block copolymer of the present invention forms a micro phase separation structure comprising an electron-donating phase and an electron-accepting phase, by the self-organization. The domain size of the micro phase is a distance over which the exciton can diffuse and thus causes an extremely efficient charge separation. Depending on the type of the block copolymer, each micro phase connects the electrodes. In such a case, an excellent carrier mobility function is exhibited. In another case, each micro phase forms a quantum well structure and improves extremely the photoelectric converting efficiency.

The present invention will be described below in more details.

First of all, described will be a block copolymer to be used as a photoelectric converting layer in the photoelectric converting device of the present invention. The block copolymer used in the present invention is characterized in that it is constructed by at least a polymer unit containing an electron-donating molecular structure and a polymer unit containing an electron-accepting molecular structure.

The term "electron-donating molecular structure" used herein denotes a structure exhibiting properties that the molecules are small in ionization potential and subject to become positive ions per se by supplying electrons to other molecules, while the term "electron-accepting molecular structure" denotes a structure exhibiting properties that the molecules are large in electron affinity and subject to become negative ions by accepting electrons from other molecules. The block copolymer used in the present invention comprises a combination of a polymer unit containing an electron-donating molecular structure and a polymer unit containing an electron-accepting molecular structure. Therefore, since the above-described electron-donating and -accepting properties are determined automatically depending on the relative relationship between the compounds having such properties to be used, a selection is arbitrarily made on combinations of such compounds that fulfill these properties.

No particular limitation is imposed on the electron-donating molecular structure as long as it has electron-donating properties in the molecular structure portion. Examples of such structures include poly- or oligo-arylene vinylene structures, poly- or oligo-anyline connecting structures, poly- or oligo-thiophene connecting structures, poly- or oligo-pyrrole connecting structures, poly- or oligo-amine connecting structures, phthalocyanine structures, and naphthalocyanine structures.

No particular limitation is imposed on the electron-accepting molecular structure as long as it has electron-accepting properties. Examples of such structures are poly- or oligo-arylene vinylene structures containing an electron-attracting group such as cyano; poly- or oligo-thiophene structures containing an electron-attracting group such as cyano; poly- or oligo-pyrrole structures containing an electron-attracting group such as cyano; poly- or oligo-phenylquinoline structures; polycyclic aromatic structures such as viologen and perylene structures; and fullerene structures.

Specific examples of the electron-accepting molecular structures are those represented by formulas (1) to (6) below, while specific examples of the electron-donating molecular structures are those represented by formulas (7) to (13) below:

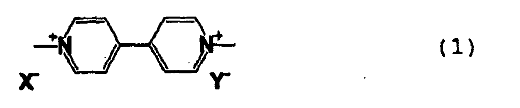

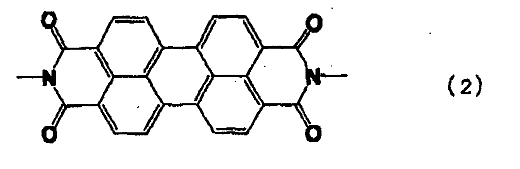

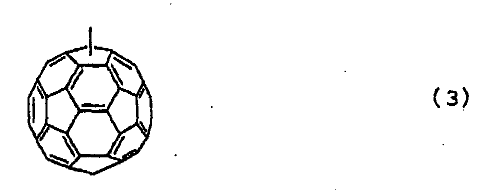

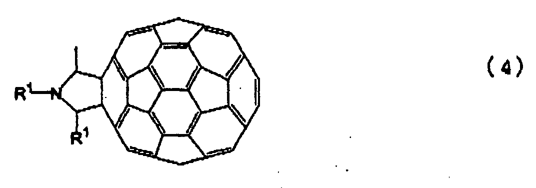

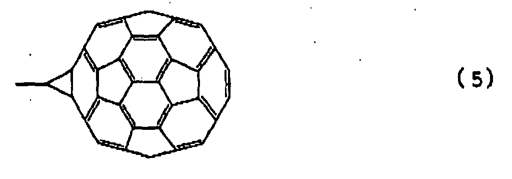

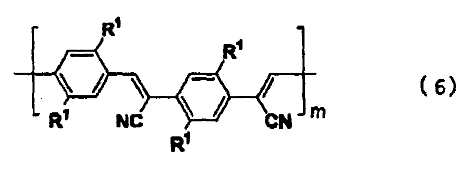

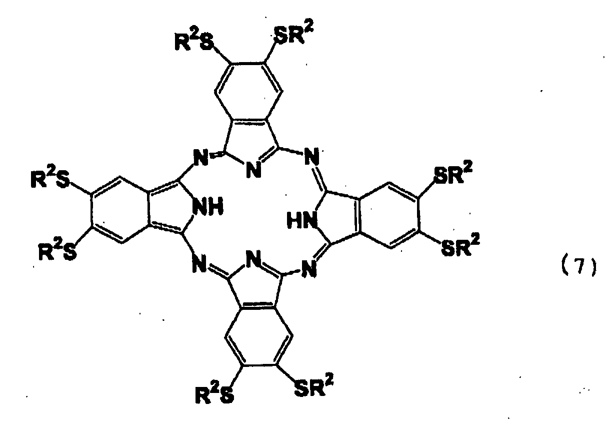

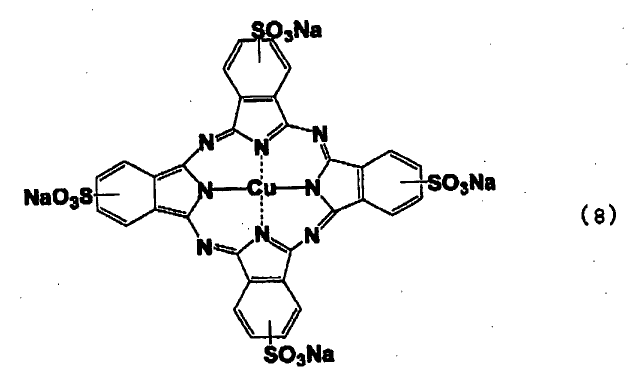

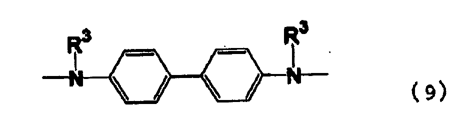

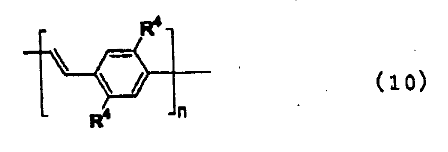

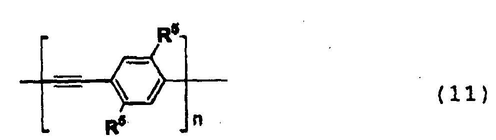

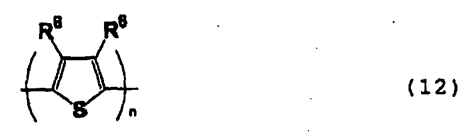

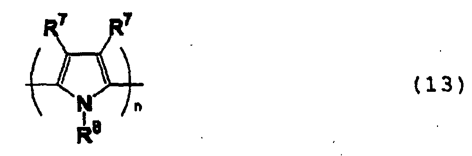

In formulas (1) to (13), R¹ and R⁴ through R⁸ may be the same or different from each other and are each independently hydrogen; a straight-chain or branched alkyl, alkenyl or alkoxyl group each having 1 to 10 carbon atoms; or an aryl, aralkyl, or aryloxy group having 6 to 12 carbon atoms.

R² and R³ may be the same or different from each other and are each independently a straight-chain or branched alkyl or alkenyl group each having 1 to 10 carbon atoms or an aryl group having 6 to 12 carbon atoms.

When a plurality of groups of R¹, R², R³, R⁴, R⁵, R⁶, or R⁷ exist in one of the formulas, they may be the same or different from each other.

Examples of the alkyl group include methyl, ethyl, propyl, i-propyl, butyl, s-butyl, t-butyl, pentyl, isopentyl, neopentyl, t-pentyl, hexyl, isohexyl, heptyl, octyl, nonyl, and decyl groups. Examples of the alkenyl group include vinyl, allyl, isopropenyl, butylenyl, pentylenyl, and hexenyl groups. Examples of the alkoxy group include methoxy, ethoxy, propoxy, i-propoxy, butoxy, s-butoxy, t-butoxy, pentoxy, isopentoxy, neopentyloxy, t-pentyloxy, hexyloxy, isohexyloxy, heptyloxy, octyloxy, nonyloxy, and decyloxy groups. Examples of the aryl group include phenyl, xylyl, tolyl, cumenyl, and naphthyl groups. Examples of the aralkyl group include benzyl and trimethyl groups. Examples of the aryloxy group include phenoxy and tolyloxy groups.

X⁻ and Y⁻ may be the same or different from each other and are each independently a counter anion selected from the group consisting of halogen anions, ClO₄⁻, BF₄⁻, PF₆⁻, CH₃COO⁻, and CH₃(C₆H₄)SO₃⁻.

In the above formulas, m and n are each independently an integer of 1 to 1,000, preferably 2 to 500.

The copolymer having these structures may be any of those having these structures in the main chain or having these structure in a side chain. However, preferred are those having these structures in the main chain.

Although these structures essentially have either electron-donating properties or electron-accepting properties, it is desirous that the structures have a carrier mobility. Whether or not these structures have a carrier mobility can be easily determined by a conventional method. For example, it can be determined by producing a homopolymer mostly comprising these structures and measuring the carrier mobility of the homopolymer by a time-of-flight method (see measuring examples described in Jpn. J. Appl. Phys., Vol. 38, pp. L1188 (1999)). The structures have a carrier mobility of usually 10⁻⁷ to 10³ cm²/V · s, preferably 10⁻⁶ to 10 cm²/ V · s. These structures preferably have electric conductivity. Whether or not these structures have electric conductivity can be determined by producing a homopolymer having these structures and measuring the electric conductivity in a conventional method after doping. The structures have an electric conductivity of generally 10⁻⁶ to 10⁶ S/cm, preferably 10⁻⁶ to 10⁴ S/cm.

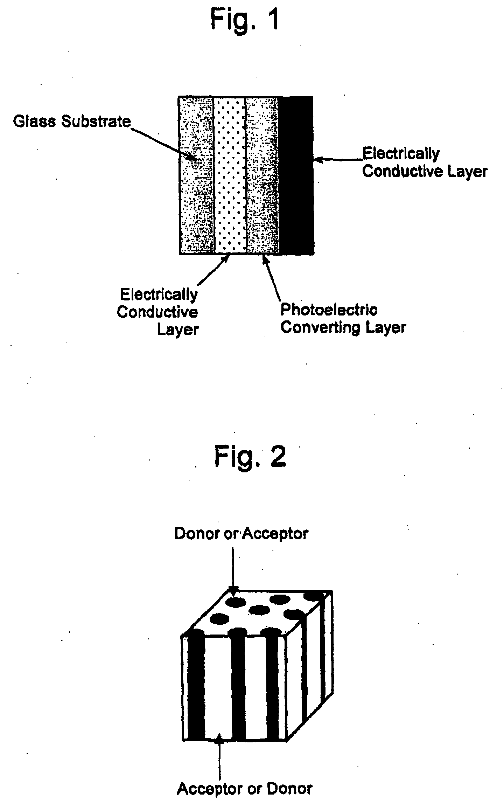

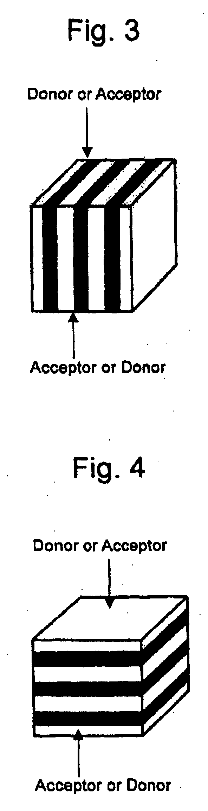

A thin film formed from the block copolymer of the present invention forms a micro phase separation structure comprising an electron-donating phase and an electron-accepting phase by the self-organization. The term "micro phase separation structure" used herein denotes a phase separation structure wherein the domain size of each phase comprising an electron-donating or -accepting phase is from several nm to several hundreds nm (generally on the order of 1 to 500 nm). The domain size can be measured with electron microscopes or scanning probe microscopes. In the thin film formed from the block copolymer of the present invention, the domain size of the micro phase separation structure is 10 times or less, preferably 5 times or less, and more preferably one time or less of the exciton diffusion length. The term "excitation diffusion length" denotes a distance at which the exciton diffuses until the amount of an exciton generated by photo absorption is 1/e. The value can be obtained by measuring the photoluminescence extinction of a polymer or an oligomer comprising each unit constituting a block copolymer, as a function of the thickness thereof. The exciton diffusion length thus measured is varied depending on whether the phase is an electron-donating phase or an electron-accepting phase but takes a value on the order of several dozen nm. Furthermore, the domain structure of the micro phase separation structure formed in the thin film formed from the block copolymer of the present invention is preferably a continuous layer or a quantum well structure. The term "continuous layer" used herein denotes a structure wherein either domain structures comprising an electron-donating phase or those comprising an electron-accepting phase in the block copolymer are continuously linked as shown in Fig. 2. The term "quantum well structure" used herein denotes a structure wherein domain structures comprising an electron-donating phase and those comprising an electron-accepting phase in the block copolymer are in an alternate laminate structure, respectively as shown in Figs. 3 and 4. The structures shown in Figs. 2, 3, and 4 are typical examples. Therefore, structures similar to those are encompassed within the above definition.

More specific examples of the block copolymers used in the present invention are as follows:

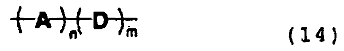

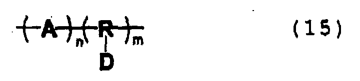

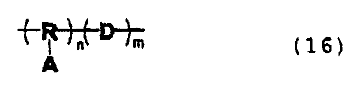

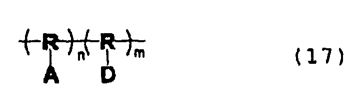

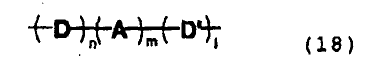

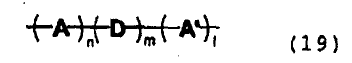

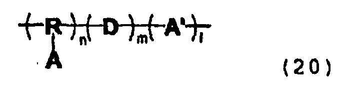

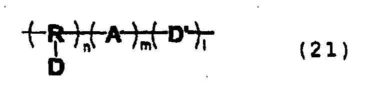

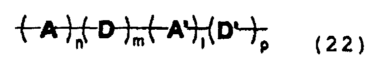

In formulas (14) to (22), A and A' are molecular groups each containing a molecular structure having electron-accepting properties and D and D' are molecular groups each containing a molecular structure having electron-donating properties. R is a polymer residue. No particular limitation is imposed on specific examples of block copolymers represented by the above formulas. However, the following copolymers are exemplified:

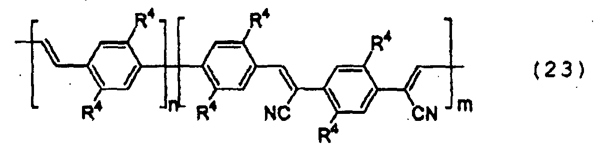

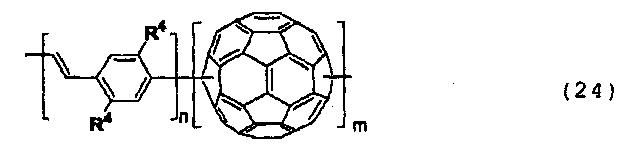

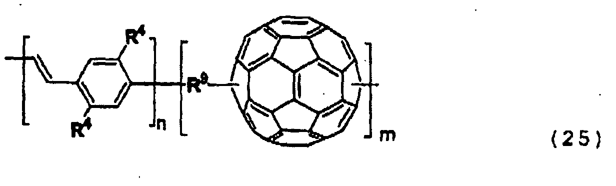

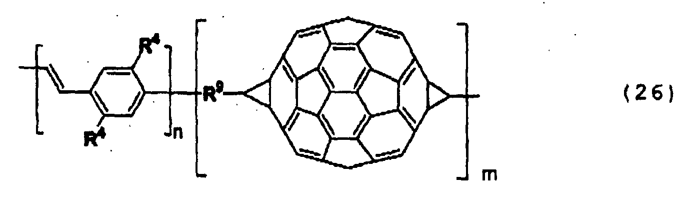

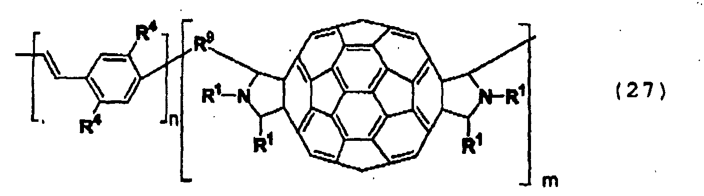

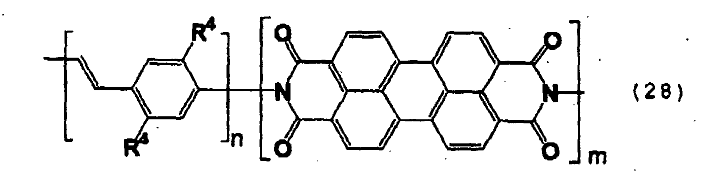

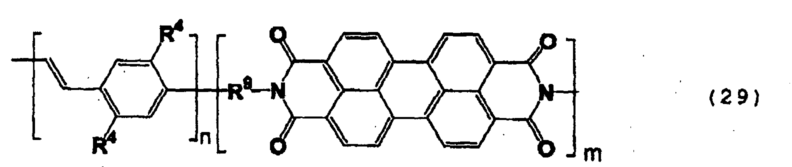

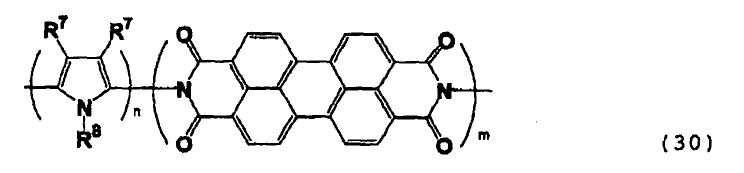

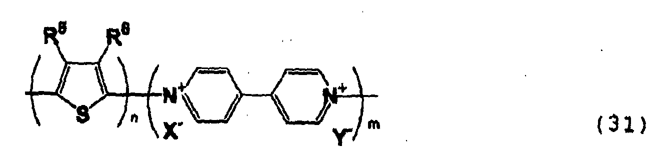

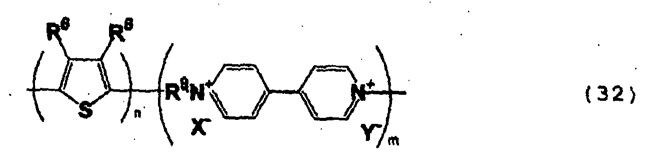

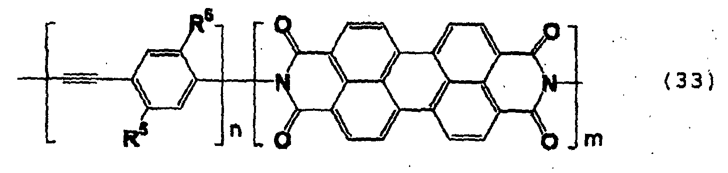

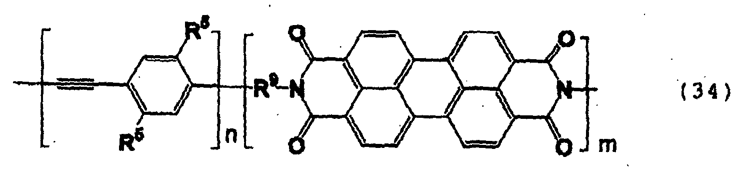

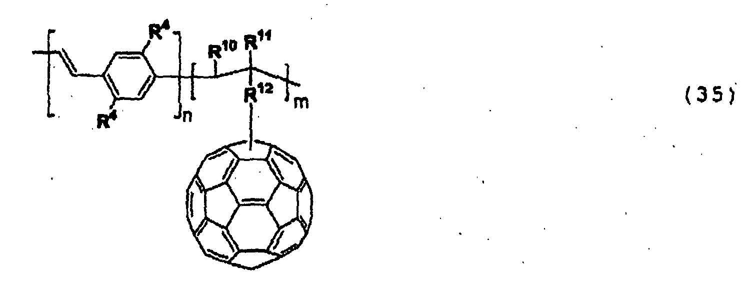

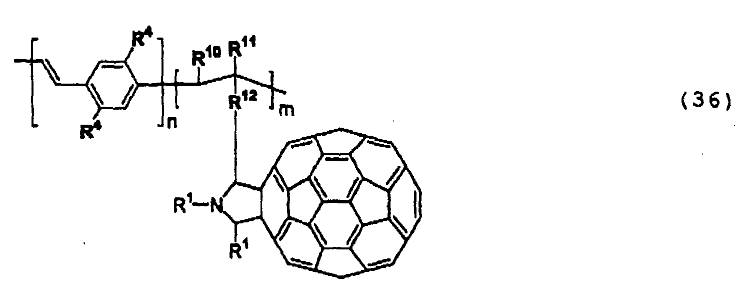

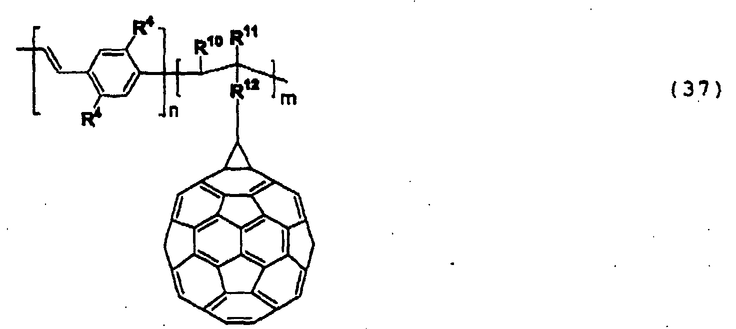

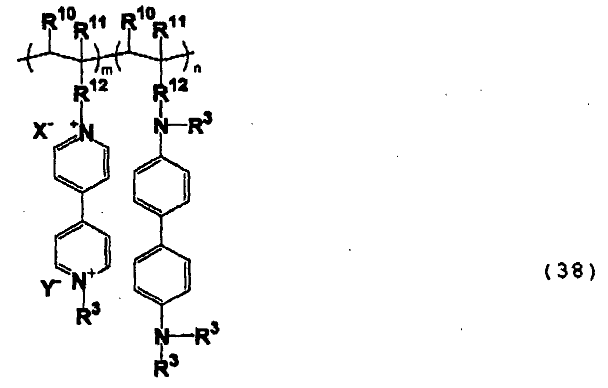

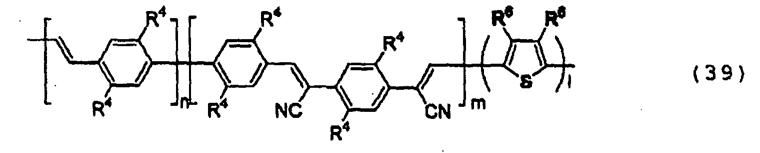

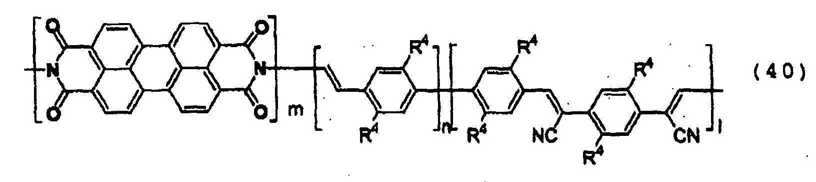

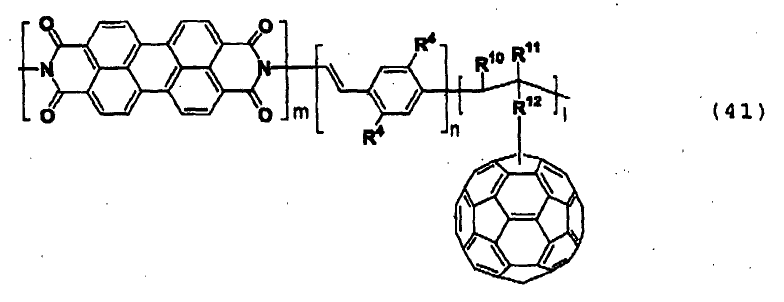

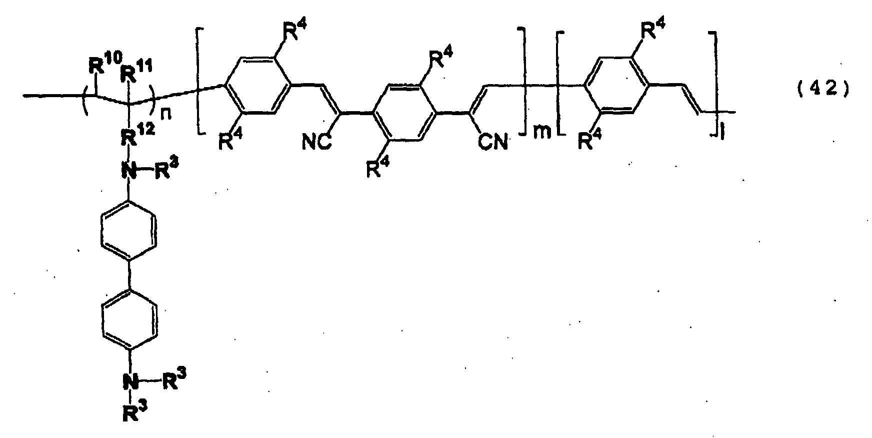

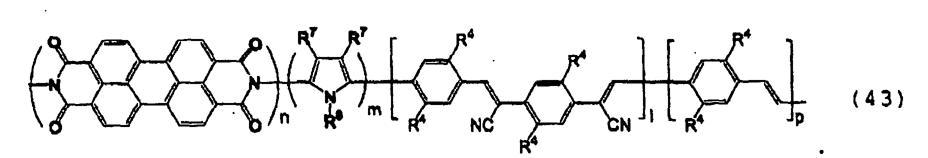

In formulas (23) to (43), R¹⁰ and R¹¹ may be the same or different from each other and are each independently hydrogen or an alkyl group having 1 to 5 carbon atoms. R⁹ and R¹² are each independently an alkylene group having 1 to 10 carbon atoms, an arylene group having 6 to 12 carbon atoms, an oxygen- or nitrogen-containing alkylene group having 1 to 10 carbon atoms, an oxygen- or nitrogen-containing arylene group having 6 to 12 carbon atoms, or a combination thereof. Examples of the alkylene group include methylene, ethylene, trimethylene, tetramethylene, and isopropylene groups. Examples of the arylene group include phenylene and tolylene groups.

In formulas (23) to (43), m is an integer of 2 to 10,000, preferably 3 to 5,000, and more preferably 4 to 2,000, while n is an integer of 2 to 10,000, preferably 3 to 5,000, and more preferably 4 to 2,000.

The molecular terminal ends of these copolymers vary depending on the method of producing the copolymers, but are generally hydrogen or hydrocarbon groups such as alkyl, alkenyl, and alkoxyl groups having 1 to 10 carbon atoms and aryl, aralkyl, and aryloxy groups having 6 to 12 carbon atoms.

These copolymers can be easily obtained by any conventional method. No particular limitation is imposed on the method. For example, the copolymer can be produced by a method wherein a dihalogen compound with a structure having electron-donating properties or electron-accepting properties is subjected to condensation polymerization with a strong base or a method wherein a monomeric compound having a structure having electron-donating properties or electron-accepting properties and various polymerizable groups is subjected to radical-, anion-, or cation-polymerization.

The present invention is characterized by using the above-described block copolymer as an photoelectric converting layer.

The photoelectric converting device of the present invention may be essentially produced by forming one or more layers of the block copolymer film over an electrically conductive substrate and then forming thereover an electrically conductive film layer. No particular limitation is imposed on the method of forming the block copolymer film layer. However, the block copolymer film layer(s) may be formed by not only vacuum deposition but also any dry filming method such as molecular beam epitaxy, ion plating and chemical vapor deposition (CVD). Alternatively, the film layer (s) can also be formed by casting, spin-coating, dip-coating, bar-coating, and screen printing methods, using a solution obtained by dissolving the block copolymer in a suitable solvent or methods wherein a substrate is dipped in such a solution so as to adsorb or bind the block copolymer.

No particular limitation is imposed on the thickness of the photoelectric converting layer. However, the thickness is usually from 1 nm to 50 µ m, preferably from 1 nm to 20 µm.

No particular limitation is imposed on the electrically conductive substrate on which the photoelectric converting layer is formed as long as electric conductivity can be obtained by a suitable method. In general, the substrate is produced by laminating a transparent electrode layer over a transparent substrate. No particular limitation is imposed on the transparent substrate. The material, thickness, size, and shape of the substrate can be properly selected depending on the purposes. For example, the substrate may be selected from colored or colorless glasses, wire glasses, glass blocks, and colored or colorless transparent resins. Specific examples are polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes. The term "transparent" used herein denotes a transmissivity of 10 to 100 percent. The substrates used herein are those having a smooth surface at ordinary temperature, which surface may be flat or curved or deformed with stress.

No particular limitation is imposed on the transparent electrode layer as long as it can achieve the purposes of the present invention. For example, the layer may be a metal film of gold, silver, chromium, copper, or tungsten or an electrically conductive film made of a metal oxide. Preferred examples of the metal oxide include tin oxide, zinc oxide, and those obtained by doping thereto trace amounts of components such as Indium Tin Oxide (ITO (In₂O₃:Sn)), Fluorine doped Tin Oxide (FTO (SnO₂:F)), and Aluminum doped Zinc Oxide (AZO (ZnO:Al)). The film thickness is usually from 10 nm to 5,000 µm, preferably from 100 nm to 3,000µm. The surface resistance (resistivity) is properly selected depending on the use of the substrate in the present invention, but is usually from 0.5 to 500 Ω/sq, preferably from 0.5 to 50 Ω/sq.

No particular limitation is imposed on the method of forming the transparent electrode layer. The method is properly selected from any conventional methods depending on the type of the above-described metal or metal oxide used as the electrode layer. In general, the method is selected from vacuum deposition, ion plating, CVD, and sputtering. In any of the methods, the transparent electrode layer is desirously formed at a substrate temperature of 20 to 700 °C.

If necessary, a semiconductor layer may be provided between the electrically conductive substrate and the photoelectric converting layer. Examples of materials used for producing the semiconductor layer include Bi₂S₃, CdS, CdSe, CdTe, CuInS₂, CuInSe₂, Fe₂O₃, GaP, GaAs, InP, Nb₂O₅, PbS, Si, SnO₂, TiO₂, WO₃, ZnO, and ZnS, among which preferred are CdS, CdSe, CuInS₂, CuInSe₂, Fe₂O₃, GaAs, InP, Nb₂O₅, PbS, SnO₂, TiO₂, WO₃, and ZnO. These materials may be used in combination. Particularly preferred are TiO₂, ZnO, SnO₂, and Nb₂O₅, while most preferred are TiO₂ and ZnO.

The semiconductor used in the present invention may be monocrystal or polycrystal. The crystal system may be selected from those of anatase, rutile, or brookite type among which preferred are those of anatase type. The semiconductor layer may be formed by any suitable conventional manner.

The semiconductor layer may be obtained by coating a nanoparticle dispersant or a sol solution, of the above-mentioned semiconductor on the substrate by any conventional method. No particular limitation is imposed on the coating method. Therefore, the coating may be conducted by a method wherein the semiconductor is obtained in the form of film by casting; spin-coating; dip-coating; bar-coating; and various printing methods such as screen-printing.

The thickness of the semiconductor layer may be properly selected but is 0.5 µm or more and 50 µm or less, preferably 1 µm or more and 20 µm or less.

The electrically conductive film layer formed on the block copolymer film layer may be a metal such as aluminum, magnesium, gold, silver, platinum, indium, copper, and chromium, an alloy of magnesium and silver, an electrically conductive carbon, or a metal paste of silver, gold, or copper.

The method of forming the electrically conductive film layer is properly selected from conventional methods depending on the type of the above-exemplified materials. Examples of conventional methods include dry filming such as vacuum deposition, ion-plating, CVD, and sputtering; spin-coating; dip-coating; bar-coating; dispensing; and various printing methods such as screen-printing.

The film thickness is usually from 0.5 nm to 5,000 µm, preferably from 10 nm to 3,000 µm. The surface resistance (resistivity) is properly selected depending on the use of the substrate of the present invention but is usually from 0.5 to 500 Ω/sq, preferably from 0.5 to 50 Ω/sq.

Alternatively, an electrically conductive polymer may be inserted between the electrically conductive substrate and the photoelectric converting layer or between the electrically conductive film layer and the photoelectric converting layer. No particular limitation is imposed on the electrically conductive polymer. Examples of the polymer include poly(3,4-ethylenedioxythiophene), polypyrrole, and polyanilline. Poly(3,4-ethylenedioxythiophene) exhibits particularly excellent properties. The electrically conductive polymer is provided to improve the contact between the electrodes and reduce leakage current.

Further alternatively, the photoelectric converting device of the present invention may be in the form of a laminate of a counter electrode substrate, the photoelectric converting layer formed by the block copolymer, and the electrically conductive substrate.

Examples of the counter electrode substrates include supporting substrates having electric conductivity per se and those obtained by forming an electrically conductive film on supporting substrates.

No particular limitation is imposed on the supporting substrate. The material, thickness, size, and shape of the substrate can be properly selected depending on the purposes. The supporting substrate may or may not have electrical conductivity and may be selected from metals such as gold and platinum, colored or colorless glasses, wire glasses, glass blocks, and colored or colorless transparent resins. Specific examples include polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes.

The substrates used herein are those having a smooth surface at ordinary temperature, which surface may be flat or curved or deformed with stress. The counter electrode substrates can be obtained by forming a film of a metal such as gold or platinum, In₂O₃:Sn, SnO₂:F, ZnO:Al by a conventional method such as vacuum deposition, electron beam vacuum deposition, or sputtering.

When the counter electrode substrates are used, an electrolyte layer may be provided between the photoelectric converting layer and the counter electrode substrate. The electrolyte layer is an ion conductive material film containing at least one or more substances selected from (a) polymeric matrixes, (b) plasticizers, and (c) supporting electrolytes and exhibits reversible oxidation-reduction properties by (a) to (c) above or (d) redox agents.

No particular limitation is imposed on materials for the polymeric matrix as long as they can form a solid or gelatinized state by itself or by addition of a plasticizer or a supporting electrolyte or a combination thereof. Polymeric compounds which have been generally used can be used.

Examples of such polymeric compounds exhibiting properties of the above-described polymeric matrix include homopolymers and copolymers of hexafluoropropylene, tetrafluoroethylene, trifluoroethylene, ethylene, propylene, acrylonitrile, vinylidene chloride, acrylic acid, methacrylic acid, methyl acrylate, ethyl acrylate, methyl methacrylate, and styrene polyfluorovinylidene. These polymers may be used individually or in combination, i.e., mixed or copolymerized.

The plasticizer used in the present invention will be described next.

Plasticizers which can be used for component (b) may be any plasticizers as long as they are solvents which are generally used for electrochemical cells or electric cells. Specific examples are acetic anhydride, methanol, ethanol, tetrahydrofuran, propylene carbonate, nitromethane, acetonitrile, dimethylformamide, dimethylsulfoxide, hexamethylphosphoamide, ethylene carbonate, dimethoxyethane, γ-butyrolactone, γ-valerolactone, sulfolane, dimethoxyethane, propionnitrile, glutaronitrile, tetrahydrofuran, adiponitrile, methoxyacetonitrile, dimethylacetoamide, methylpyrrolidinone, dimethylsulfoxide, dioxolane, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol. Particularly preferred examples include propylene carbonate, ethylene carbonate, dimethylsulfoxide, dimethoxyethane, acetonitrile, γ -butyrolactone, sulfolane, dioxolane, dimethylformamide, dimethoxyethane, tetrahydrofuran, adiponitrile, methoxyacetonitrile, dimethylacetoamide, methylpyrrolidinone, dimethylsulfoxide, trimethyl phosphate, and triethyl phosphate. These plasticizers may be used alone or in combination.

The supporting electrolyte used in the present invention will be described next.

The supporting electrolyte may be salts, acids, alkalis, ionic liquids which are generally used in the field of electrochemistry or electric cells.

No particular limitation is imposed on the salts. For example, the salts may be inorganic ion salts such as alkali metal salts and alkaline earth metal salts, quaternary ammonium salts, cyclic quaternary ammonium salts, and quaternary phosphonium salts. Particularly preferred are Li salts.

Specific examples of the salts include Li, Na, and K salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

The salts may be any of quaternary ammonium salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻, more specifically (CH₃)₄NBF₄, (C₂H₅)₄NBF₄, (n-C₄H₉)₄NBF₄, (C₂H₅)₄NBr, (C₂H₅)₄NClO₄, (n-C₄H₉)₄NClO₄, CH₃(C₂H₅)₃NBF₄, (CH₃)₂(C₂H₅)₂NBF₄, (CH₃)₄NSO₃CF₃, (C₂H₅)₄NSO₃CF₃, (n-C₄H₉)₄NSO₃CF₃, and those represented by the following formulas: 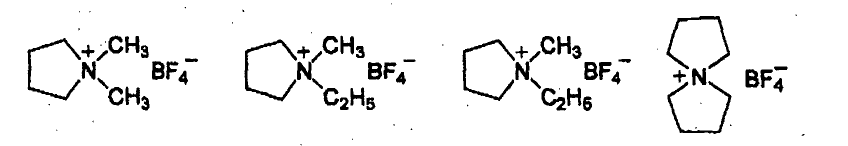 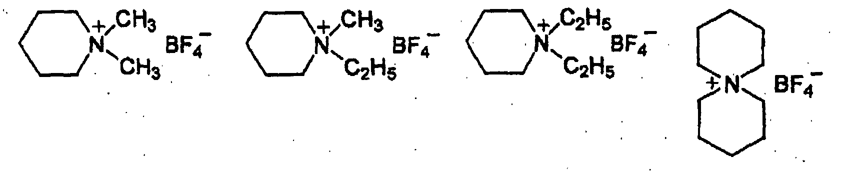 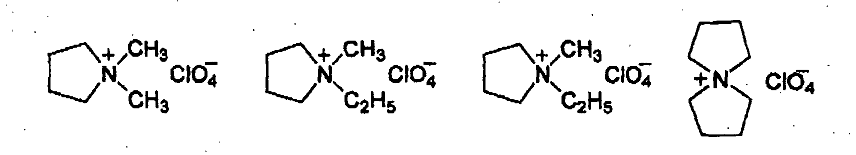 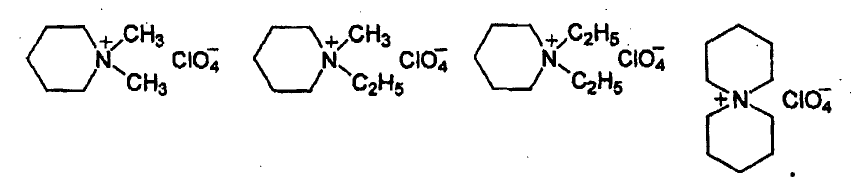 Furthermore, the salts may be any of phosphonium salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻, more specifically (CH₃)₄PBF₄, (C₂H₅)₄PBF₄, (C₃H₇)₄PBF₄, and (C₄H₉)₄PBF₄.

Mixtures of these salts.may also be used.

No particular limitation is imposed on the acids, which, therefore, may be inorganic acids or organic acids. Specific examples of the acids are sulfuric acid, hydrochloric acid, phosphoric acids, sulfonic acids, and carboxylic acids.

No particular limitation is imposed on the alkalis which, therefore, may be sodium hydroxide, potassium hydroxide, and lithium hydroxide.

No particular limitation is imposed on the ionic liquids. The term "ionic liquids" used herein denotes a salt comprising only ion pairs without solvent components, in a melted state (liquid state) at ordinary temperature, more specifically a salt comprising ion pairs which has a melting point of 20 °C or below and will be in a liquid state at a temperature exceeding 20 °C.

The ionic liquids may be used alone or in combination.

Examples of the ionic liquids include those represented by the following formulas: 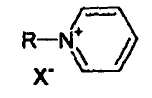 wherein R is an alkyl group having 2 to 20, preferably 2 to 10 carbon atoms and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; 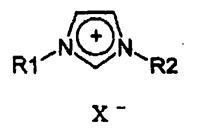 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and 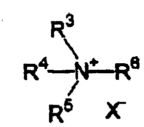 wherein R³, R⁴, R⁵, and R⁶ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

No particular limitation is imposed on the amount of the supporting electrolyte to be used. The supporting electrolyte may be contained in the ion conductive material film in an amount of usually 0.1 percent by mass or more, preferably 1 percent by mass or more, and more preferably 10 percent by mass or more and 70 percent by mass or less, preferably 60 percent by mass or less, and more preferably 50 percent by mass or less.

The redox agents used in the present invention will be described next.

The redox agents are those enabling a reversible electrochemical oxidation-reduction reaction and are not limited in type. The redox agent may be only either one of an oxidant or a reductant or a mixture thereof mixed at a suitable molar ratio.

Alternatively, a respective oxidation-reduction pair of the polymeric matrix, plasticizer, or supporting electrolyte may be added such that the polymeric matrix, plasticizer, or supporting electrolyte exhibits an electrochemical response. Examples of the materials capable of making polymeric matrix, plasticizer, or supporting electrolyte exhibit such properties include metallocenium salts such as ferrocenium having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻ and halogens such as iodine, bromine, and chlorine.

The electrolyte layer used in the present invention may contain another component. Examples of the component include ultraviolet absorbing agents. Although not restricted, examples of the ultraviolet absorbing agents include organic ultraviolet absorbing agents such as compounds having a benzotriazole molecule structure or a benzophenone molecule structure.

Examples of the compound having a benzotriazole molecule structure include those represented by formula (44) below:

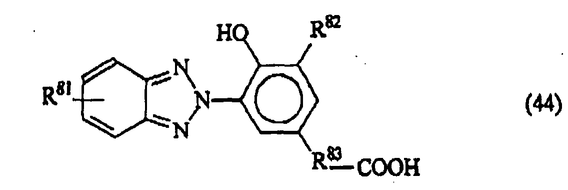

In formula (44), R⁸¹ is hydrogen, halogen or an alkyl group having 1 to 10, preferably 1 to 6 carbon atoms. Specific examples of the halogen are fluorine, chlorine, bromine, and iodine. Specific examples of the alkyl group include methyl, ethyl, propyl, i-propyl, butyl, t-butyl and cyclohexyl groups. R⁸¹ is usually substituted at the 4- or 5-position of the benzotriazole ring but the halogen atom and the alkyl group are usually located at the 4-position. R⁸² is hydrogen or an alkyl group having 1 to 10, preferably 1 to 6 carbon atoms. Examples of the alkyl group include methyl, ethyl, propyl, i-propyl, butyl, t-butyl, and cyclohexyl groups. R⁸³ is an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

Specific examples of the compounds represented by formula (44) include
3-(5-chloro-2H-benzotriazole-2-yl)-5-(1,1-dimethylethyl)-4-hydroxy-benzene propanoic acid, 3-(2H-benzotriazole-2-yl)-5-(1,1-dimethylethyl)-4-hydroxy-benzene ethanoic acid,
3-(2H-benzatriazole-2-yl)-4-hydroxybenzene ethanoic acid,
3-(5-methyl-2H-benzotriazole-2-yl)-5-(1-methylethyl )-4-hydroxybenzene propanoic acid,
2-(2'-hydroxy-5'-methylphenyl)benzotriazole,
2-[2'-hydroxy-3',5'-bis(α,α-dimethylbenzyl) phenyl] benzotriazole, 2-(2'-hydroxy-3', 5'-di-t-butylphenyl)benzotriazol,
2-(2'-hydroxy-3'-t-butyl-5'-methylphenyl)-5-chloro benzotriazole, and
3-(5-chloro-2H-benzotriazole-2-yl)-5-(1,1-dimethyl ethyl)-4-hydroxy-benzene propanoic acid octylester.

Specific examples of the compound having a benzophenone molecule structure include those represented by the following formulas:

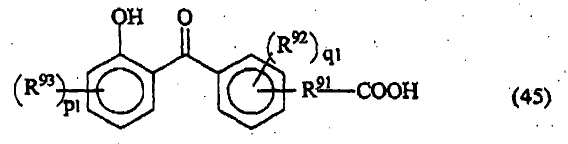

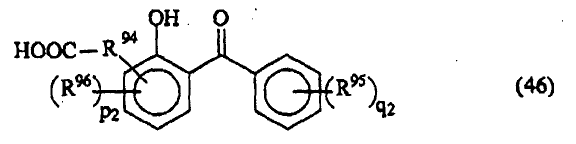

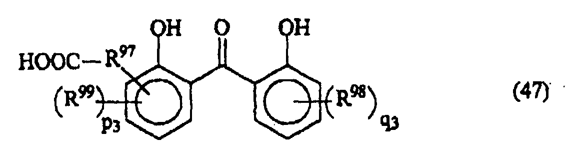

In formulas (45) to (47), R⁹², R⁹³, R⁹⁵, R⁹⁶, R⁹⁸, and R⁹⁹ may be the same or different from each other and are each independently a hydroxyl group or an alkyl or alkoxy group having 1 to 10, preferably 1 to 6 carbon atoms. Examples of the alkyl group include methyl, ethyl, propyl, i-propyl, butyl, t-butyl, and cyclohexyl groups. Specific examples of the alkoxy group are methoxy,.ethoxy, propoxy, i-propoxy, and butoxy groups.

R⁹¹, R⁹⁴, and R⁹⁷ are each independently an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

In the above formulas, p1, p2, p3, q1, q2, and q3 are each independently an integer of 0 to 3.

Preferred examples of the compounds having a benzophenone molecule structure, represented by formulas (45) to (47) include
2-hydroxy-4-methoxybenzophenone-5-carboxylic acid,
2,2'-dihydroxy-4-methoxybenzophenone-5-carboxylic acid, 4-(2-hydroxybenzoyl)-3-hydroxybenzen propanoic acid, 2,4-dihydroxybenzophenone,
2-hydroxy-4-methoxybenzophenone,
2-hydroxy-4-methoxybenzophenone-5-sulfonic acid,
2-hydroxy-4-n-octoxybenzophenone,
2,2'-dihydroxy-4,4'-dimethoxybenzophenone,
2,2',4,4'-tetrahydroxybenzophenone, and
2-hydroxy-4-methoxy-2'-carboxybenzophenone.

Needless to mention, two or more of these ultraviolet absorbing agents may be used in combination.

The use of the ultraviolet absorbing agent is optional. No particular limitation is imposed on the amount of the ultraviolet absorbing agent to be used. However, if the agent is used, it may be contained in the electrolyte layer described below in an amount of 0.1 percent by mass or more, preferably 1 percent by mass or more and 20 percent by mass or less, preferably 10 percent by mass or less.

The electrolyte layer used in the present invention may be produced as a redox electrolyte film. The method of producing the redox electrolyte film will be described as follows.

The redox electrolyte film used in the present invention can be produced by forming a mixture obtained by blending any of arbitrary components such as a plasticizer, a supporting electrolyte, a redox agent, or an ultraviolet absorbing agent in a polymeric matrix component, into a film in a conventional manner. No particular limitation is imposed on the forming method. The film may be formed by extrusion, casting, or spin- or dip-coating.

Extrusion may be conducted in a conventional manner wherein a polymeric matrix is mixed with any of arbitrary components such as a plasticizer, a supporting electrolyte, a redox agent, an ultraviolet absorbing agent and formed into a film after being heat-melted.

Casting is conducted by mixing a polymeric matrix with any of arbitrary components such as a plasticizer, a supporting electrolyte, a redox agent, an ultraviolet absorbing agent, adjusting the viscosity of the mixture by adding a suitable diluent, and coating and drying the diluted mixture with a conventional coater normally used for casting thereby forming the mixture into a film. Examples of the coater include doctor coaters, blade coaters, rod coaters, knife coaters, reverse roll coaters, gravure coaters, spray coaters, and curtain coaters among which a suitable one is selected depending on the viscosity and film thickness.

Spin coating is conducted by mixing a polymeric matrix with any of arbitrary components such as a plasticizer, a supporting electrolyte, a redox agent, an ultraviolet absorbing agent, adjusting the viscosity of the mixture by adding a suitable diluent, and coating and drying the diluted mixture with a commercially available spin-coater thereby forming the mixture into a film.

Dip coating is conducted by mixing a polymeric matrix with any of arbitrary components such as a plasticizer, a supporting electrolyte, a redox agent, an ultraviolet absorbing agent, adjusting the viscosity of the mixture by adding a suitable diluent so as to obtain a solution of the mixture, dipping and lifting a suitable substrate therein coating, and drying the solution thereby forming the mixture into a film.

The redox electrolyte film obtained by any of the above-described methods exhibits an ionic conductivity of generally 1 x 10⁻⁷ S/cm or higher, preferably 1 x 10⁻⁶ S/cm or higher, and more preferably 1 x 10⁻⁵ S/cm or higher, at room temperature. The ionic conductivity can be obtained by a conventional method such as AC impedance method.

No particular limitation is imposed on the thickness of the redox electrolyte film. The lower limit is usually 1 µm or more, preferably 10 µm or more, while the upper limit is usually 3 mm or less, preferably 1 mm or less.

### [Best Modes for Carrying out the Invention]

The present invention will be described in more details with reference to the following examples but is not limited thereto.

### (Synthesis Example 1)

2 g of 1,4-bis(chloromethyl)-2,5-bis(hexyloxy)benzene and 0.05 g of 4 -tert-butylbenzylchloride were dissolved in 100 ml of tetrahydrofuran (THF). To the mixture with cooled with ice and stirred was added 60 ml of a solution of 1 M tert-butoxypotassium (t-BuOK)/THF all at once. Thereafter, stirring was continued at a temperature of 25 °C for 10 hours, followed by addition of 2 g of 2,5-bis(hexyloxy)-terephthalaldehyde and 2 g of 1,4-bis(cyanomethyl)-2,5-bis(hexyloxy)benzene and 10-hour stirring. The reaction solution was then poured in methanol, and then a precipitate was then filtered out. The precipitate was vacuum-dried thereby obtaining a block copolymer represented by the following formula wherein n = 20 and m = 30:

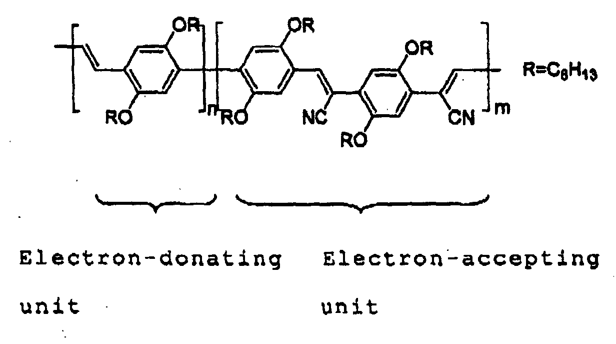

### (Synthesis Example 2)

4 g 2,5-dihexyloxy-p-tolylaldemine /15 ml anhydrous dimethylformamide (DMF) were added dropwise to 2 g tert-butoxypotassium (t-BuOK)/60 ml anhydrous DMF and stirred at a temperature of 80 °C for 2 hours. The reaction solution was poured to and then stirred in 400 ml HCl (1N)/800 ml chloroform, and components solved in chloroform were dried out in vacuo at a temperature of 50 °C thereby obtaining 1 g of a red solid. The red solid was dissolved in 500 ml of tetrahydrofuran (THF), and thereto were added 2 g of 2,5-bis(hexyloxy)-terephthalaldehyde and 2 g of 1,4-bis(cyanomethyl)-2,5-bis(hexyloxy)benzene. The mixture was stirred at a temperature of 50 °C for 10 hours. The reaction solution was poured to methanol. The precipitate was filtered out and vacuum-dried thereby obtaining a block copolymer represented by the formula (n = 7, m = 20) below:

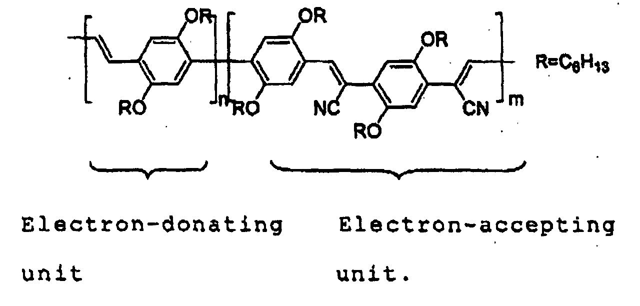

### (Synthesis Example 3)

4 g 2,5-dihexyloxy-*p*-tolylaldemine/15 ml anhydrous dimethylformamide (DMF) were added dropwise to 2 g tert-butoxypotassium (t-BuOK)/60 ml anhydrous DMF and stirred at a temperature of 80 °C for 2 hours. The reaction solution was poured to and then stirred in 400 ml HCl (1N)/800 ml chloroform, and components solved in chloroform were dried out in vacuo at a temperature of 50 °C thereby obtaining 1 g of a red solid. Thereafter, an alkoxyamine wherein 2,2,6,6-tetramethylpiperidine-1-oxyl (TEMPO) and bromine were added to styrene was synthesized and reacted with magnesium in dry THF thereby obtaining a Grignard reagent. The Grignard reagent was added dropwise to the dried THF solution of the red solid and stirred at a temperature of 60 °C for 12 hours. The reaction solution was added to 2,000 ml of ethanol containing 50 ml of a 1 N hydrochloric acid solution. The precipitated red solid was dissolved in chloroform. The resulting solution was dehydrated and then dried thereby obtaining a TEMPO-added red solid.

2.3 ml of 6-bromohexane-1-ol were added dropwise to 50 ml of an ethanol solution dissolving 1.5 g of 4-hydroxybenzaldehyde and 0.6 g of sodium hydroxide, at room temperature and refluxed for 48 hours. After removal of the solvent, the residue was dissolved in chloroform and then washed with water and dehydrated with magnesium sulfate thereby removing the solvent. Further, the residue was dissolved in 300 ml of anhydrous DMF, and to the solution while being cooled in an ice bath were added 20 ml DMF/2 g 4-vinylbenzylchloride. The mixture was stirred at a temperature of 50 °C for 10 hours. After removal of the solvent, the residue was dissolved in ethyl acetate and then washed with water and dehydrated. The resulting product was purified with a flush column chromatography. The resulting purified product was dissolved in 400 ml of chlorobenzene dissolving 1 g of C60 and 0.4 g of N-methylglycin and refluxed for 20 hours. After removal of the solvent, purification was conducted with a flush column chromatography thereby obtaining a C60 derivative.

The TEMPO-added red solid obtained above and the C60 derivative were dissolved in toluene and then stirred at a temperature of 100 °C for 6 hours under a nitrogen atmosphere after degassed. The reaction solution was added to methanol, and the solid thus formed was filtered out and dried thereby obtaining a block polymer represented by the formula (n = 7, m = 10) below:

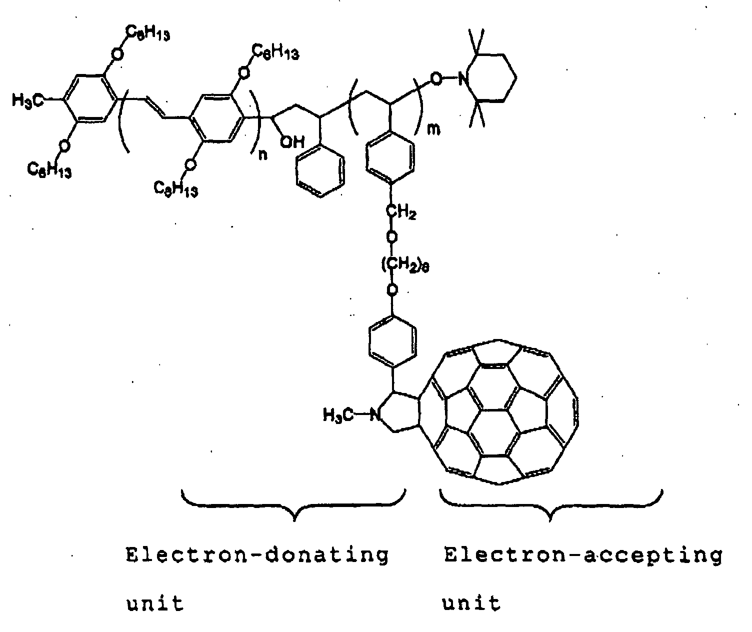

### (Example 1: Preparation of Photoelectric Converting Device)

A chloroform solution of the block copolymer of Synthesis Example 1 (about 10 g/L) was spin-coated over a 5 cm square ITO glass (a transparent electrically conductive glass obtained by forming an Sn-doped In₂O₃ film on a glass substrate) with a film resistance of 10 Ω/sq, which had been cleaned by alkali-washing and plasma-ozone washing. The coated glass was dried sufficiently thereby obtaining a photoelectric converting layer. The thickness of the layer was 100 nm. It was confirmed through an observation made on the surface of the layer that a uniform and clear film was formed. It was also confirmed through an observation with an electron microscope that the domain size of the electron-donating phase and that of the electron-accepting phase are 20 nm and 30 nm, respectively and the phase structure was a quantum well structure as shown in Fig. 4. The photoelectric converting layer was left standing at a temperature of 80 °C for 20 hours, but no particular change was observed.

Two types of homopolymers (Compound A below, n = 20; Compound B below, m = 30) each comprising the electron-donating unit or the electron-accepting unit of the block copolymer used in this example were measured of the exciton diffusion length and carrier mobility. The exciton diffusion length and carrier mobility of Compound A were about 15 nm and 2 x 10⁻⁵ cm²/V·s. The exciton diffusion length and carrier mobility of Compound B were about 18 nm and 3 x 10⁻⁵ cm²/V·s.

Next, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated to the device, and the electric current thereof when short-circuited was measured thereby confirming that a current of 2.1 µ A was obtained and the device exhibited excellent photoelectric converting properties.

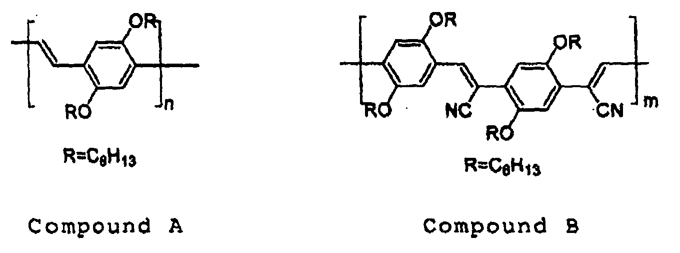

### (Example 2: Preparation of Photoelectric Converting Device)

A photoelectric converting layer was prepared with the same procedures of Example 1 except for using the block copolymer of Synthesis Example 2. The thickness of the layer was about 100 nm. It was confirmed through an observation made on the surface of the layer that a uniform and clear film was formed. It was also confirmed through an observation with an electron microscope that the domain size of the electron-donating phase and that of the electron-accepting phase are 8 nm and 20 nm, respectively and the phase structure was a structure wherein the electron-accepting phases form a continuous layer as shown in Fig. 2. The photoelectric converting layer was left standing at a temperature of 80 °C for 20 hours, but no particular change was observed.

Two types of homopolymers (Compound A below, n = 7; Compound B below, m = 20) each comprising the electron-donating unit or the electron-accepting unit of the block copolymer used in this example were measured of the exciton diffusion length and carrier mobility. The exciton diffusion length and carrier mobility of Compound A were about 13 nm and 1 x 10⁻⁵ cm²/V·s. The exciton diffusion length and carrier mobility of Compound B were about 15 nm and 4 x 10⁻⁵ cm²/V · s.

Next, aluminum was deposited at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated to the device, and the electric current thereof when short-circuited was measured thereby confirming that a current of 3.3 µ A was obtained and the device exhibited excellent photoelectric converting properties.

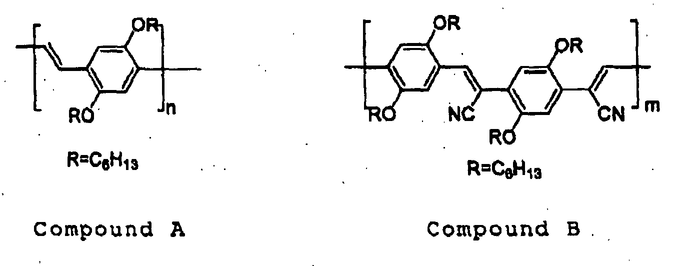

### (Example 3: Preparation of Photoelectric Converting Device)

A photoelectric converting layer was prepared with the same procedures of Example 1 except for using the block copolymer of Synthesis Example 3. The thickness of the layer was about 120 nm. It was confirmed through an observation made on the surface of the layer that a uniform and clear film was formed. It was also confirmed through an observation with an electron microscope that the domain size of the electron-donating phase and that of the electron-accepting phase are 8 nm and 10 nm, respectively and the phase structure was a quantum well structure as shown in Fig. 3. The photoelectric converting layer was left standing at a temperature of 80 °C for 20 hours, but no particular change was observed.

Two types of homopolymers (Compound A below, n = 7; Compound B below, m = 10) each comprising the electron-donating unit or the electron-accepting unit of the block copolymer used in this example were measured of the exciton diffusion length and carrier mobility. The exciton diffusion length and carrier mobility of Compound A were about 13 nm and 1 x 10⁻⁵ cm²/V·s. The exciton diffusion length and carrier mobility of Compound B were about 13 nm and 2 x 10⁻⁵ cm²/V·s.

Next, aluminum was deposited at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated to the device, and the electric current thereof when short-circuited was measured thereby confirming that a current of 1.5 µ A was obtained and the device exhibited excellent photoelectric converting properties.

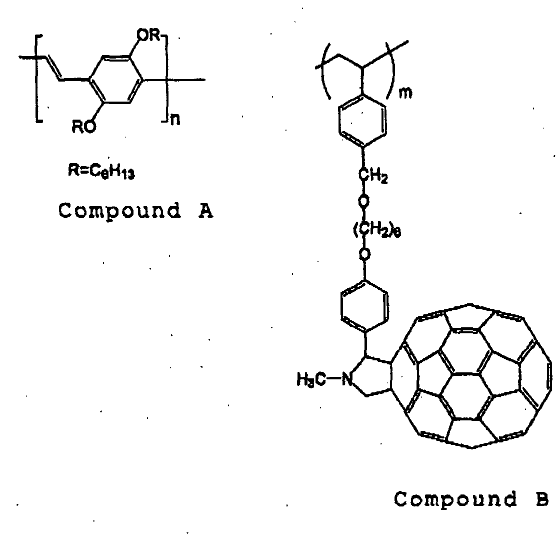

### (Comparative Example 1)

A chloroform solution of a mixture of Polymer A (Compound A below) and Polymer B (Compound B below) (about 10 g/L after mixing Polymers A and B at equimolecular) was spin-coated over a 5 cm square ITO glass with a film resistance of 10 Ω/sq, which had been cleaned by alkali-washing and plasma-ozone washing. The coated glass was dried sufficiently thereby obtaining a photoelectric converting layer with a thickness of about 5 µm. It was confirmed through a visual observation that the surface of the layer was turbid. The photoelectric converting layer was left standing at a temperature of 80 °C for 20 hours, but the turbidity did not disappear.

Next, aluminum was deposited at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated to the device, and'the electric current thereof when short-circuited was measured thereby confirming that the current obtained was 0.6 µA.

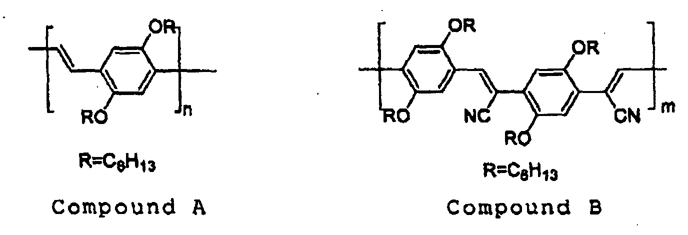

### [Applicability in the Industry]

The photoelectric converting device of the present invention has a photoelectric converting layer with a micro phase separation structure enabling efficient charge separation and excellent carrier mobility and thus can provide high efficient photovoltaic generation. The photoelectric converting device has features that it can be easily produced and is less burden to the environment upon production and deposition.

### [Brief Description of the Drawings]

Fig. 1 shows a typical layer structure of a photoelectric converting device according to the present invention.
Fig. 2 shows an example wherein the domain structure of a photoelectric converting device according to the present invention is a continuous layer.
Fig. 3 shows an example wherein the domain structure of a photoelectric converting device according to the present invention is a quantum well structure.
Fig. 4 shows another example wherein the domain structure of a photoelectric converting device according to the present invention is a quantum well structure.

## Claims

1. A photoelectric converting device wherein it has a photoelectric converting layer comprising a block copolymer constructed by at least a polymer unit containing an electron-donating molecular structure and a polymer unit containing an electron-accepting molecular structure.

2. The photoelectric converting device according to claim 1 wherein said electron-donating molecular structure and said electron-accepting molecular structure exist in the main chain of each polymer unit.

3. The photoelectric converting device according to claim 1 wherein said polymer unit containing an electron-donating molecular structure and said polymer unit containing an electron-accepting molecular structure have carrier mobility, respectively.

4. The photoelectric converting device according to claim 1 wherein the domain size of the micro phase separation structure formed by said block copolymer is 10 times or less of the exciton diffusion length.

5. The photoelectric converting device according to claim 1 wherein the domain structure of the micro phase separation structure formed by said block copolymer forms a continuous layer.

6. The photoelectric converting device according to claim 1 wherein the domain structure formed by the block copolymer is a quantum well structure.
